# EUROPEAN PATENT APPLICATION

(11) **EP 4 422 061 A1**
(43) Date of publication of application: **28.08.2024**
(21) Application number: 23275026.5
(22) Date of filing: 21.02.2023
(51) Int. Cl.: H02M 7/5387, H02M 7/757, H02M 1/32, H02M 7/00, H01L 23/473, H01L 25/11, H05K 7/14

(54) **ASSEMBLY**

(71) Applicant: General Electric Technology GmbH, 5400 Baden (CH)
(72) Inventor: DAVIDSON, Colin, Stafford (GB); BARKER, Carl, Stafford (GB)
(74) Representative: Openshaw & Co.

(57) **Abstract**

There is provided a diode valve assembly comprising a diode valve (30) and a sealed enclosure (32), the diode valve (30) including at least one diode, the or each diode housed inside the sealed enclosure (32), the sealed enclosure (32) filled with a fluid insulant (46).

## Description

The invention relates to a diode valve assembly, preferably for use in high voltage direct current power transmission networks.

In high voltage direct current (HVDC) power transmission networks AC power is typically converted to DC power for transmission via overhead lines, under-sea cables and/or underground cables. This conversion removes the need to compensate for the AC capacitive load effects imposed by the power transmission medium, i.e. the transmission line or cable, and reduces the cost per kilometre of the lines and/or cables, and thus becomes cost-effective when power needs to be transmitted over a long distance. DC power can also be transmitted directly from offshore wind parks to onshore AC power transmission networks.

The conversion between DC power and AC power is utilised where it is necessary to interconnect DC and AC networks. In any such power transmission network, converters (i.e. power converters) are required at each interface between AC and DC power to effect the required conversion from AC to DC or from DC to AC.

According to a first aspect of the invention, there is provided a diode valve assembly comprising a diode valve and a sealed enclosure, the diode valve including at least one diode, the or each diode housed inside the sealed enclosure, the sealed enclosure filled with a fluid insulant.

In embodiments of the invention, the fluid insulant may have an electrical breakdown strength that is higher than an electrical breakdown strength of air at atmospheric pressure.

In further embodiments of the invention, the fluid insulant may be a gas insulant. Preferably the gas insulant is pressurised above atmospheric pressure. The gas insulant may be or may include, but is not limited to, air, CO₂, sulphur hexafluoride (SF₆), fluoronitrile or a mixture thereof.

In other embodiments of the invention, the fluid insulant may be a liquid insulant. The liquid insulant may be or may include, but is not limited to, a mineral oil, a natural ester or a synthetic ester.

There are different ways of achieving electrical connection with the or each diode housed inside the sealed enclosure. One exemplary way is by the diode valve including one or more electrical connections extending out of the sealed enclosure.

The sealed enclosure may be made of a variety of materials, such as a metallic material, a polymeric material or a composite material.

The shape and form of the sealed enclosure may vary depending on the internal space requirements of the or each housed diode and/or the external space availability for storing the diode valve assembly. In one example, the sealed enclosure may be in the form of a tank. In another example, the sealed enclosure may be in the form of a tube.

The diode valve may include a plurality of diodes. The arrangement of the plurality of diodes in the sealed enclosure may vary. The plurality of diodes may be arranged in at least one diode stack. The or each diode stack may be arranged to have a vertical orientation inside the sealed enclosure or a horizontal orientation inside the sealed enclosure.

In embodiments of the invention, the diode valve assembly may include one or more support structures configured to support the or each diode inside the sealed enclosure. The or each support structure may be made of a solid insulant.

In further embodiments of the invention, the diode valve assembly may include a resistive element connected in series or in parallel with the diode valve. The resistive element may be a linear or variable resistive element. The resistive element may be housed inside the sealed enclosure, or may be located outside the sealed enclosure, or may be located inside a separate sealed or unsealed enclosure. The diode valve assembly may include a plurality of resistive elements, each of which is connected in series or in parallel with the diode valve.

In still further embodiments of the invention, the diode valve assembly may include a voltage monitoring device coupled to or associated with the or each diode. The voltage monitoring device may be configured to provide an indication when the or each diode is supporting a voltage. For example, the voltage monitoring device may include a visual indication device that is configured to provide a visual indication when the or each diode is supporting a voltage.

It will be appreciated that the use of the terms "first" and "second", and the like, in this patent specification is merely intended to help distinguish between similar features, and is not intended to indicate the relative importance of one feature over another feature, unless otherwise specified. It will also be appreciated that any two features described as being electrically connected may be directly connected, i.e. with no other device arranged in electrical connection between the two features, or indirectly connected, i.e. with one or more devices arranged in electrical connection between the two features.

Within the scope of this application it is expressly intended that the various aspects, embodiments, examples and alternatives set out in the preceding paragraphs, and the claims and/or the following description and drawings, and in particular the individual features thereof, may be taken independently or in any combination. That is, all embodiments and all features of any embodiment can be combined in any way and/or combination, unless such features are incompatible. The applicant reserves the right to change any originally filed claim or file any new claim accordingly, including the right to amend any originally filed claim to depend from and/or incorporate any feature of any other claim although not originally claimed in that manner.

Preferred embodiments of the invention will now be described, by way of non-limiting examples, with reference to the following figures in which:
Figure 1 shows a point-to-point bipole HVDC system;
Figure 2 shows a point-to-point symmetrical monopole HVDC system;
Figure 3 shows a diode valve assembly according to a first embodiment of the invention;
Figure 4 shows a diode valve assembly according to a second embodiment of the invention;
Figure 5 shows diode valve assemblies according to third and fourth embodiments of the invention;
Figure 6 shows a diode valve assembly according to a fifth embodiment of the invention;
Figure 7 shows a diode valve assembly according to a sixth embodiment of the invention;
Figure 8 shows a diode valve assembly according to a seventh embodiment of the invention; and

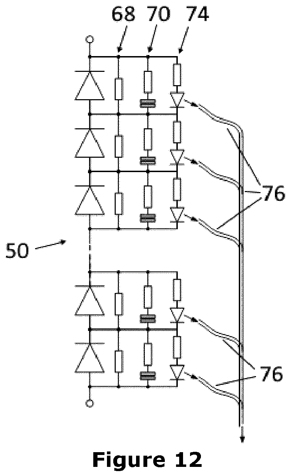

Figures 9 to 12 show various configurations of components of the diode valve assembly of the invention.

The figures are not necessarily to scale, and certain features and certain views of the figures may be shown exaggerated in scale or in schematic form in the interests of clarity and conciseness.

The following embodiments of the invention are described with reference to high voltage power transmission networks, but it will be appreciated that the following embodiments of the invention are applicable mutatis mutandis to power transmission networks and electrical circuits operating at other voltage levels.

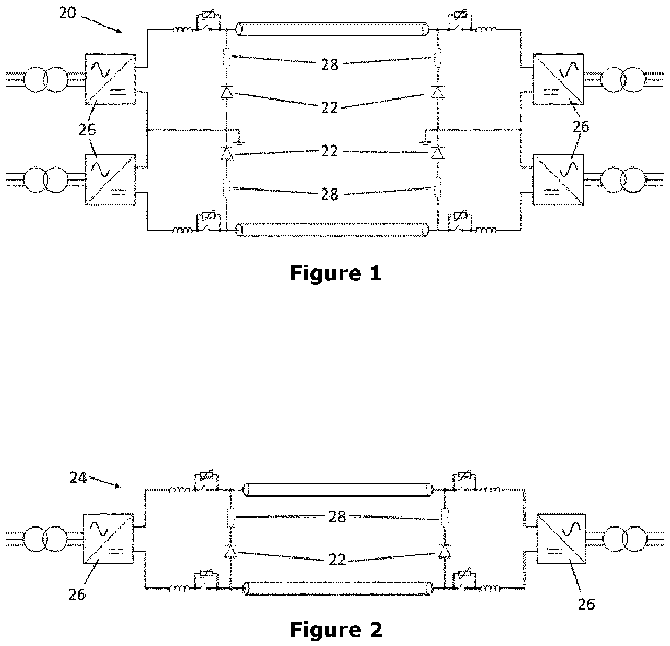

Figure 1 shows a point-to-point bipole HVDC system 20 comprising a plurality of diode valves 22, while Figure 2 shows a point-to-point symmetrical monopole HVDC system 24 comprising a plurality of diode valves 22. In each system, each diode valve 22 is connected in reverse-bias between the two DC terminals of an HVDC converter 26, and an optional resistor 28 may be connected in series with each diode valve 22.

Having diode valves 22 in the locations shown in Figure 1 and Figure 2 eliminates the risk of damage that might arise from the reversal of cable voltage, which takes place when a voltage transient created by a power transmission cable fault reaches the impedance mismatch at the boundary between the converter station and the power transmission cable. The risk of voltage reversal is not only harmful to the power transmission cable but also raises design implications for the converter station. This is because a near doubling of the rate of rise of fault current is caused by the voltage reversal, which means that a power transmission cable fault at some distance from the converter station (e.g. 200 km) creates a much more severe fault current in the converter station than a fault originating within the converter station. As a result, the converter station must be designed to address such fault current levels, such as increasing the size of DC reactors to limit the rate of rise of fault current or improving the performance of associated DC circuit breakers.

Since the individual diodes making up a given diode valve 22 operate at different electrical potentials with respect to ground, they need to be protected from atmospheric pollution (which would otherwise tend to collect and deposit itself on insulating surfaces, thereby creating a risk of flashover). The same problem applies to HVDC converter valves, which are conventionally housed in large air-conditioned buildings to prevent this risk. However, providing an air-conditioned building just for a diode valve 22 would be expensive and occupy a large amount of space, especially if the building had to be dedicated only to the diode valve 22 (because for example there is no HVDC converter in the station).

The invention seeks to implement a diode valve in a simple and cost-effective manner to insulate and protect the diode valves from the environment, with minimal disturbance to the rest of the station. In particular, the configuration of the diode valve assembly of the invention allows the diode valve to be housed inside a weatherproof enclosure located in the station but outside a building, which is more cost-effective and space-saving than having a dedicated air-conditioned building for the diode valve. This enables the diode valve assembly to be configured as a free-standing, self-contained, outdoor-mounted equipment with minimal need for civil works and minimum control/monitoring/protective functions.

Non-limiting embodiments of the invention are described below, with reference to the figures.

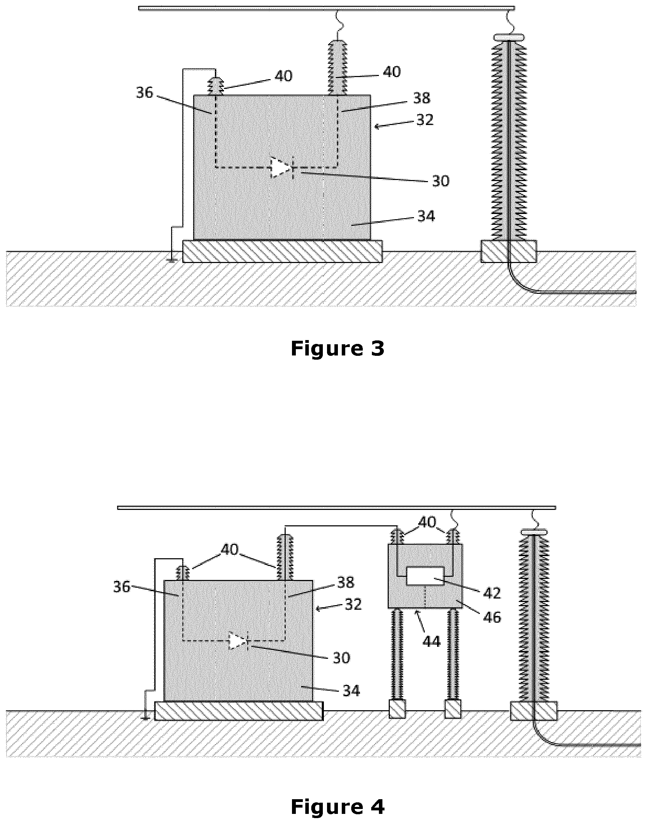

A diode valve assembly according to an embodiment of the invention is shown in Figure 3. The diode valve assembly comprises a diode valve 30 and a hermetically sealed enclosure 32. In use, the diode valve 30 is electrically connected in reverse bias between DC terminals of an HVDC converter of a HVDC power transmission system. The diode valve 30 may be located in or near a converter station containing the HVDC converter, or near a non-converter station, e.g. a DC switching station.

In the embodiment shown the diode valve 30 is exemplified by a single diode, but it will be appreciated that the diode may be replaced by a plurality of diodes, preferably series-connected diodes. The diode is housed inside the sealed enclosure 32.

The sealed enclosure 32 is in the form of a metallic tank 32. Preferably the tank 32 is made of steel. The tank 32 can be at earth potential so that it requires no insulation and can simply be mounted on, e.g., a concrete pad foundation. The tank 32 is filled with a liquid insulant 34, which may be a mineral oil, a natural ester or a synthetic ester.

The liquid insulant 34 provides the electrical insulation between different parts of the electrical circuit so as to reduce internal clearances within the tank 32 to values of the order of, e.g., a few cm. Hence, filling the tank 32 with the liquid insulant 34 allows the tank 32 to be compact in size without compromising on the required insulation, and also allows the tank 32 to rest directly on the ground. To reduce the dimensions of the tank 32 to manageable levels, it is advantageous for the liquid insulant 34 to have an electrical breakdown strength that is higher than an electrical breakdown strength of air at atmospheric pressure. In other embodiments, the liquid insulant 34 may be replaced by a gas insulant that is preferably pressurised above atmospheric pressure. The gas insulant may be or may include, but is not limited to, compressed air, compressed CO₂, sulphur hexafluoride (SF₆), fluoronitrile or a fluoronitrile/CO₂ mixture.

Anode and cathode connections 36,38 of the diode valve 30 extend out of the top of the tank 32 through bushings 40. In other embodiments, the anode connection 36 and/or the cathode connection 38 of the diode valve 30 may extend out of the side of the tank 32. In use, the anode and cathode connections 36,38 are electrically connected to the HVDC power transmission system so that the diode valve 30 is electrically connected in reverse bias between DC terminals of an HVDC converter of a HVDC power transmission system.

The tank 32 is located outdoors in the DC yard of the station, close to a termination end of a power transmission cable (or a power transmission line in other embodiments). In the embodiment shown, the diode valve 30 is installed at the positive pole of a bipole HVDC system, so that the cathode of the diode is at line potential and therefore needs a high insulation level while the anode is at DC neutral potential or ground. If the diode valve 30 is installed at the negative pole of a bipole HVDC system, the anode of the diode is at line potential and therefore needs a high insulation level while the cathode is at DC neutral potential or ground. If the diode valve 30 is connected to a symmetrical monopole HVDC system, both anode and cathode would need a high insulation level.

A resistor 42 may be connected in series with the diode valve 30. Alternatively the resistor 42 may be replaced by a plurality of resistors, preferably series-connected resistors. As shown in Figure 4, the resistor 42 is connected to the cathode of the diode, but it will be understood that the resistor 42 may alternatively be connected to the anode of the diode. The resistor 42 is housed inside a separate sealed enclosure 44 (preferably a tank 44) that is preferably filled with a fluid insulant 46, examples of which are described throughout the specification. The fluid insulant 46 aids the cooling down, and limits a temperature rise, of the resistor 42 after a fault. Electrical connections 48 of the resistor 42 extend out of the sealed enclosure 44 through bushings 40. Alternatively the resistor 42 may be inside the same tank 32 as the diode. The resistor 42 is not required to be housed inside a sealed enclosure but instead may be housed in an unsealed enclosure, e.g. a ventilated box with openings to permit air flow therethrough.

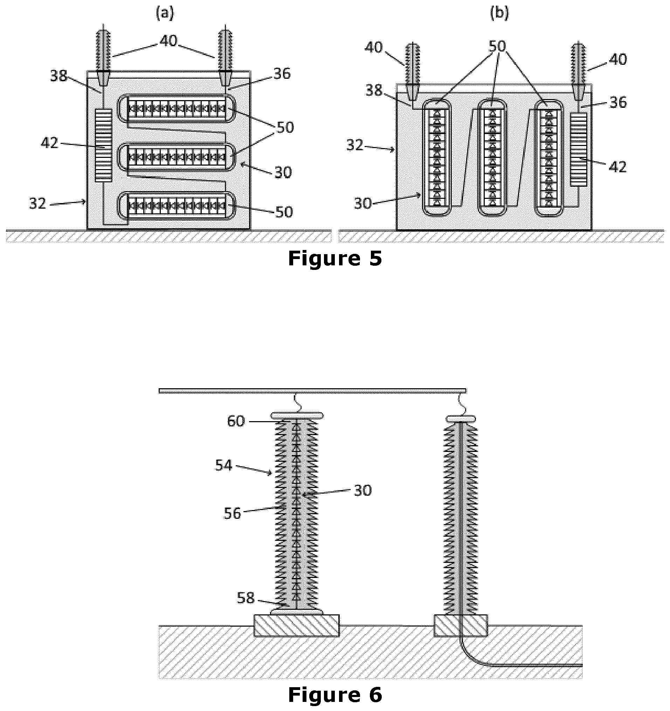

When the diode valve 30 includes a plurality of diodes, the plurality of diodes may be arranged (preferably connected in series) in at least one diode stack 50. The plurality of diodes are clamped under pressure to form the or each diode stack 50. The or each diode stack 50 may include, but is not limited to, 5 to 20 diodes. Figure 5a shows a plurality of diode stacks 50 arranged in a horizontal orientation inside the tank 32, while Figure 5b shows a plurality of diode stacks 50 arranged in a vertical orientation inside the tank 32. The orientation of the diode stacks 50 can be selected to reduce the height and/or footprint of the tank 32. Also, the vertical orientation of the diode stacks 50 provides greater mechanical stability by allowing longer diode stacks 50 to be created without the risk of the diode stacks 50 collapsing under their own weight.

An optional resistor 42 (or resistors 42) may be connected in series with the diode stacks 50. The resistor(s) 42 may be housed inside the tank 32 as shown in Figure 5 or may be located outside the tank 32, preferably inside its own sealed or unsealed enclosure.

The diode valve assembly may include support structures 52 configured to mechanically support the diode(s), particularly the diode stacks 50, inside the tank 32. The support structures 52 are preferably made of a solid insulant. Non-limiting examples of solid insulants include kraft paper, pressboard, epoxy resin and glass-fibre-reinforced composites.

Hence, there are locations inside the tank 32 where the voltage between live parts of the diode valve 30 and the tank 32 is supported by the combination of solid and liquid insulation components. In such a mixed dielectric system, the dimensions of both the solid and liquid insulation components need to be adequate enough to withstand electrical stresses occurring at different times, including just after energisation, in steady-state and after a power transmission cable fault.

In AC applications, this does not pose a problem because the voltage will be divided between the two insulation components in inverse proportion to their relative permittivities. Since most solid and liquid insulants have relative permittivities in the range of 2 to 5, the voltage sharing between the solid and liquid insulants is relatively uniform.

However, in DC applications, the voltage sharing is determined by the resistivities of the insulants, and not the permittivities of the insulants. Resistivity is highly temperature dependent and can vary over a much wider range than permittivity. After a prolonged application of DC voltage, a space charge can build up in the solid part of the insulation, which reduces electrical stress across the liquid insulation at the expense of the solid insulation. However, if the applied DC voltage ceases or is rapidly reversed in polarity, most of the voltage will then appear across the liquid insulation. Hence, both the liquid and solid insulation need to be thick enough to withstand most of the applied voltage, which would not be the case in an AC application operating at a comparable voltage.

A diode valve assembly according to an embodiment of the invention is shown in Figure 6. The diode valve assembly of Figure 6 is similar in structure and operation to the diode valve assembly of Figure 3, except that the sealed enclosure 54 of the diode valve assembly of Figure 6 is in the form of a tube 54 filled with the fluid insulant 56.

Anode and cathode connections 58,60 of the diode valve 30 respectively extend out of the bottom and top of the tube 54. In use, the anode and cathode connections 58,60 are electrically connected to the HVDC power transmission system so that the diode valve 30 is electrically connected in reverse bias between DC terminals of an HVDC converter of a HVDC power transmission system.

The tube 54 may be made from a composite material such as filament-wound glass-reinforced polymer, which is excellent at withstanding internal overpressure. Hence, the fluid insulant 56 may come in the form of pressurised gas. Moulded silicone elastomer sheds may be provided on the outside of the tube 54 to provide sufficient creepage distance.

The diode valve 30 comprises a plurality of diodes that are arranged vertically inside the tube 54. The plurality of diodes may be configured as a diode stack 50. This allows the diode stack 50 to be suspended vertically, using solid insulant support structures 52, from the top of the tube 54 and inside the tube 54 so that no bending moment is applied to the diode stack 50 as a result of the weight of the diodes and so that the footprint occupied by the diode valve assembly is minimised.

In the embodiment shown, the diode valve 30 is installed at the positive pole of a bipole HVDC system, so that the cathode of the diode is at line potential and therefore needs a high insulation level while the anode is at DC neutral potential or ground. If the diode valve 30 is installed at the negative pole of a bipole HVDC system, the anode of the diode is at line potential and therefore needs a high insulation level while the cathode is at DC neutral potential or ground. If the diode valve 30 is connected to a symmetrical monopole HVDC system, both anode and cathode would need a high insulation level.

In bipole applications (Figure 1) where the diode valve 30 is connected between the HVDC terminal and a low-voltage terminal (either ground or the DC neutral terminal), the low-voltage terminal of the diode valve 30 may be placed at the bottom of the tube 54 while the high-voltage terminal of the diode valve 30 may be placed at the top of the tube 54. In this way, the bottom of the tube 54 can be mounted on a concrete foundation either directly or via only a small insulator support. In symmetrical monopole applications (Figure 2), the insulation of the diode valve assembly has to be rated for the full DC voltage between the bottom of the diode valve 30 and ground.

Whilst an option would be to include all diodes in a single, very long diode stack, the total number of diodes for a complete diode valve could be in the range of hundreds (e.g. 100 to 200). This would lead to a tall and narrow structure that is vulnerable to horizontal accelerations due to, for example, earthquakes or strong winds.

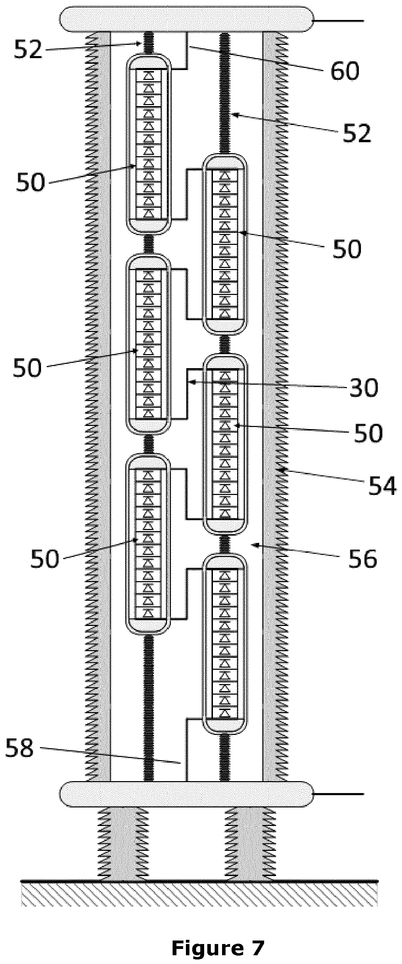

One option would be to divide the diodes into several, moderate-length, diode stacks 50 that are connected in series. As shown in Figure 7, the diode stacks 50 could be arranged in a staggered fashion. This still has the effect of maintaining an overall small footprint of the diode valve assembly while keeping the height to a level that is just sufficient to provide enough creepage and clearance between the top and bottom of the diode valve 30, whilst not being too tall and narrow so as to be vulnerable to horizontal accelerations.

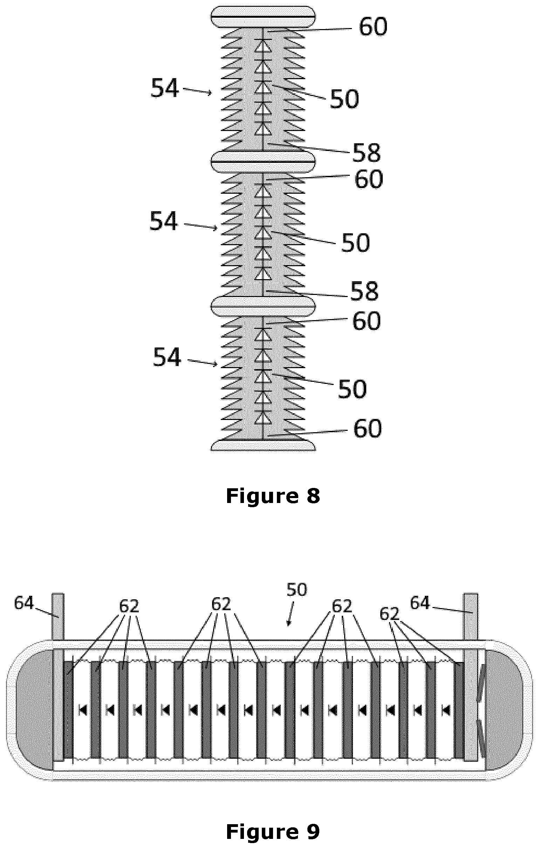

Alternatively, as shown in Figure 8, the diode valve assembly may include multiple tubes 54, each of which houses a respective diode stack 50. The diode stacks 50 are electrically connected in series through the anode and cathode connections 58,60 extending out of the respective tubes 54. The benefit of the approach in Figure 8 is that the multiple tubes 54 are easier to transport in the vertical orientation to avoid bending stresses on the diode stacks 50 during transportation to site, and the multiple tubes 54 can be attached together to form the diode valve assembly on site.

Figure 9 shows an exemplary configuration of the diode stack 50 in which the diodes are clamped under pressure and are separated from each other by intervening heatsinks 62. Busbars 64 are connected to the end diodes of the diode stack 50.

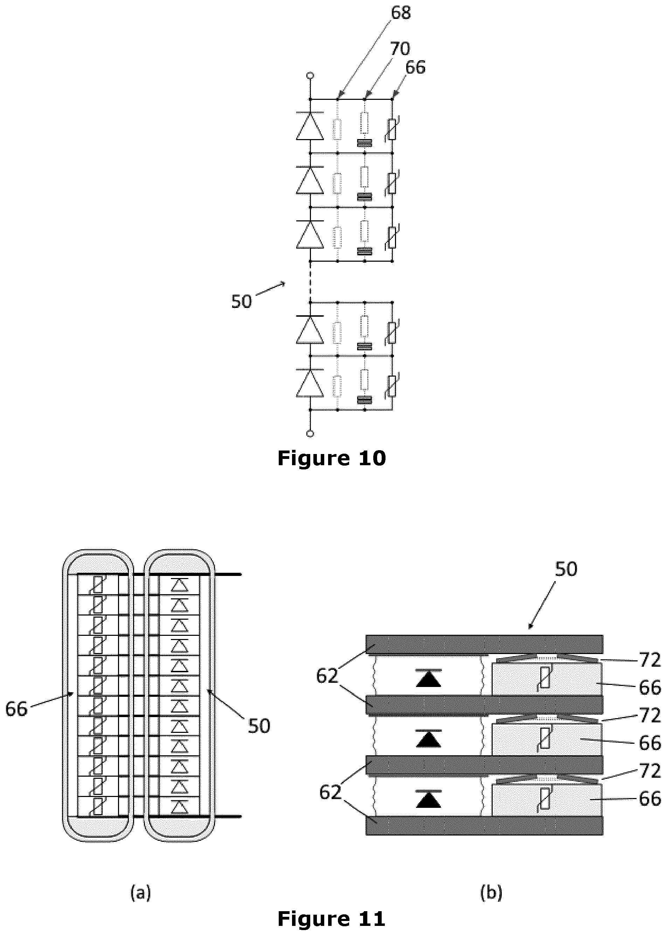

Optionally each diode, or a plurality of diodes, may be protected from overvoltage by a parallel-connected metal-oxide varistor (MOV) 66, which assists with the distribution of reverse voltage between the series-connected diodes and also provides overvoltage protection. Each MOV 66 could be included in addition to, or in place of, a resistive circuit 68 (e.g. a DC grading resistor) and/or a snubber or damping circuit 70 (e.g. an R-C circuit), as shown in Figure 10. In order to minimise the space occupied by these auxiliary components (MOV 66, resistive circuit 68, snubber or damping circuit 70), they can be mounted on heatsink blocks (typically copper or aluminium) that separate each diode from the next diode in the diode stack 50.

To achieve good electrical and thermal contact, the MOVs 66 may be clamped under pressure in a separate stack electrically connected to the diode stack 50 (Figure 11a) or may be clamped under pressure to the same heatsinks 62 as the diodes in the diode stack 50 (Figure 11b). In Figure 11b, a separate, lower-force spring 72 (e.g. a disc spring) is provided for the MOV 66. This takes advantage of the fact that the clamping force for the MOV 66 is significantly lower than that of the diode. In order to avoid applying an uneven clamping pressure to the diodes (which could crack the silicon material of the diodes), the point of application of the clamping force to the stack as a whole could be offset from the centre-line of the diodes so as to be slightly towards the centre-line of the MOVs 66.

The diode valve assembly of the invention may include a voltage monitoring device coupled to or associated with the or each diode in order to provide a diode health monitoring system. This allows the health of the diodes to be constantly monitored in order to check how many of the diodes are still intact and raise an alarm if the number becomes too low. A maintenance shutdown can then be scheduled to repair or replace the failed diodes or replace the entire diode valve by a spare unit.

In a preferred embodiment, a respective passive voltage monitoring circuit 74 is connected in parallel with each diode. The passive voltage monitoring circuit 74 comprises a high-ohmic-value resistor in series with a light emitting diode (LED), which lights up when the diode is supporting a voltage. The light emitted by each LED can be sensed by a respective light sensor. Preferably a respective optical fibre 76 is arranged to receive light emitted by each LED, and the optical fibres 76 extend out of the sealed enclosure so that light sensors outside the sealed enclosure can sense the light transmitted by the optical fibres. Presence of light means that the diode is supporting a voltage and thereby is healthy. Absence of light can be taken to mean that the diode has failed.

During operation of the HVDC system, the diodes are supporting reverse voltages almost all of the time. The voltage across the diodes only falls to a low on-state voltage briefly during power transmission cable faults. The healthy monitoring system will therefore need to be deactivated during a power transmission cable fault because the temporary loss of optical signals from all of the diodes will be incorrectly interpreted as a failure of all of the diodes.

It will be appreciated that the above numerical values are merely intended to help illustrate the working of the invention and are not necessarily limiting on the scope of the invention.

The listing or discussion of an apparently prior-published document or apparently prior-published information in this specification should not necessarily be taken as an acknowledgement that the document or information is part of the state of the art or is common general knowledge.

Preferences and options for a given aspect, feature or parameter of the invention should, unless the context indicates otherwise, be regarded as having been disclosed in combination with any and all preferences and options for all other aspects, features and parameters of the invention.

## Claims

1. A diode valve assembly comprising a diode valve (30) and a sealed enclosure (32,54), the diode valve (30) including at least one diode, the or each diode housed inside the sealed enclosure (32,54), the sealed enclosure (32,54) filled with a fluid insulant (34,56).

2. A diode valve assembly according to Claim 1 wherein the fluid insulant (34,56) has an electrical breakdown strength that is higher than an electrical breakdown strength of air at atmospheric pressure.

3. A diode valve assembly according to any one of the preceding claims wherein the fluid insulant (34,56) is a gas insulant.

4. A diode valve assembly according to Claim 1 or Claim 2 wherein the fluid insulant (34,56) is a liquid insulant.

5. A diode valve assembly according to any one of the preceding claims wherein the diode valve (30) includes one or more electrical connections (36,38,58,60) extending out of the sealed enclosure (32,54).

6. A diode valve assembly according to any one of the preceding claims wherein the sealed enclosure (32,54) is made of a metallic material, a polymeric material or a composite material.

7. A diode valve assembly according to any one of the preceding claims wherein the sealed enclosure (32) is in the form of a tank (32).

8. A diode valve assembly according to any one of the preceding claims wherein the sealed enclosure (54) is in the form of a tube (54).

9. A diode valve assembly according to any one of the preceding claims wherein the diode valve (30) includes a plurality of diodes, the plurality of diodes arranged in at least one diode stack (50), the or each diode stack (50) arranged to have a vertical orientation inside the sealed enclosure (32,54).

10. A diode valve assembly according to any one of Claims 1 to 8 wherein the diode valve (30) includes a plurality of diodes, the plurality of diodes arranged in at least one diode stack (50), the or each diode stack (50) arranged to have a horizontal orientation inside the sealed enclosure (32,54).

11. A diode valve assembly according to any one of the preceding claims including one or more support structures configured to support the or each diode inside the sealed enclosure (32,54), the or each support structure made of a solid insulant.

12. A diode valve assembly according to any one of the preceding claims including a resistive element (42,68) connected in series or in parallel with the diode valve (30).

13. A diode valve assembly according to Claim 12 wherein the resistive element (42,68) is housed inside the sealed enclosure (32,54).

14. A diode valve assembly according to any one of the preceding claims including a voltage monitoring device (74) coupled to or associated with the or each diode, wherein the voltage monitoring device (74) is configured to provide an indication when the or each diode is supporting a voltage.

15. A diode valve assembly according to Claim 14 wherein the voltage monitoring device (74) includes a visual indication device that is configured to provide a visual indication when the or each diode is supporting a voltage.
